# EUROPEAN PATENT SPECIFICATION

(11) **EP 0 499 752 B1**
(45) Date of publication and mention of the grant of the patent: **12.06.1996**
(21) Application number: 91312090.3
(22) Date of filing: 30.12.1991
(51) Int. Cl.: H01L 21/304

(54) **Method for dividing a semiconductor wafer comprising a semiconductor layer and a metal layer into chips**
Verfahren zum Zerteilen eines Halbleiterwafers, der eine Halbleiterschicht und eine Metallschicht aufweist, in Chips
Procédé pour diviser des wafers semi-conducteurs comportant une couche semi-conductrice et une couche de métal, en chips

(30) Priority: 12.02.1991 JP 42704/91
(43) Date of publication of application: 26.08.1992
(73) Proprietor: MITSUBISHI DENKI KABUSHIKI KAISHA, Tokyo (JP)
(72) Inventor: Notani, Yoshihiro, c/o MITSUBISHI DENKI K. K., Mizuhara 4-chome, Itami-shi, Hyogo-ken (JP)
(74) Representative: Beresford, Keith Denis Lewis

(56) References cited:
- EP-A- 0 359 373
- FR-A- 2 646 018
- US-A- 4 142 893
- SOLID STATE TECHNOLOGY. vol. 15, no. 9, September 1972, WASHINGTON US pages 27- 28; M.D. PENNINGS ET AL.: 'New semiconductor wafer dicing system'

## Description

### FIELD OF THE INVENTION

The present invention relates to a method of producing a plurality of semiconductor chips and, more particularly, to an improvement of processing precision and working efficiency in dicing process.

### BACKGROUND OF THE INVENTION

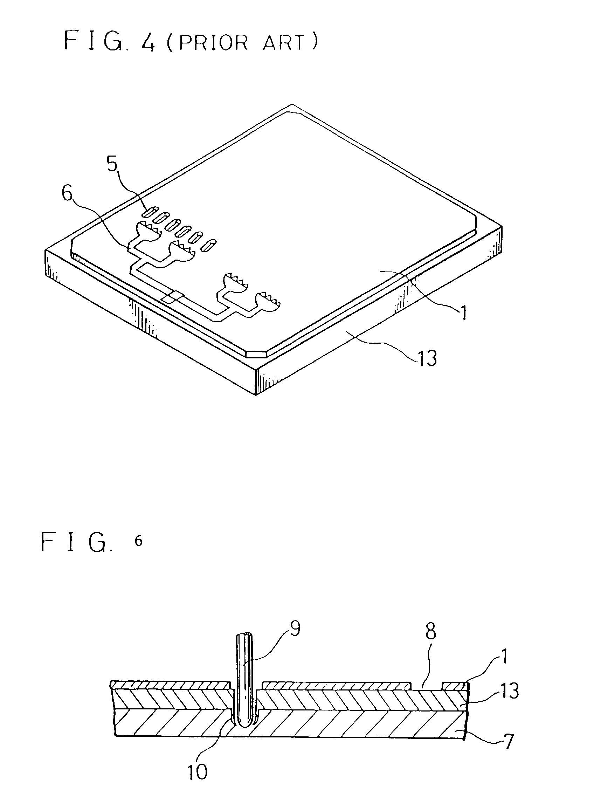

Figure 4 is a perspective view showing a structure of a semiconductor device which is produced by a prior art method. In Figure 4, reference numeral 1 designates a semiconductor substrate. An IC pattern 6 is produced on the surface of the substrate 1. A metal layer 13, which serves as both of a grounding electrode and a heat sink, is provided on the rear surface of the substrate 1. The metal layer 13 is connected with the surface of the substrate 1 through via-holes 5.

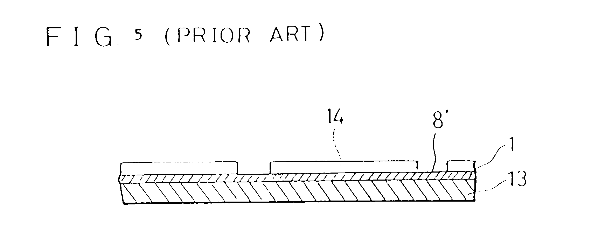

Another method for dividing the wafer into chips is conducted by etching using a mask as shown in Figure 5. More specifically, resist films 14 serving as etching mask are formed on the semiconductor substrate 1 except for regions 8' corresponding to the dicing lines 8 shown in Figure 5 and then the wafer is soaked into an etchant. In this method, although no burr is generated on the rear surface of the chip, it is difficult to control the dimension of the side surfaces of the chip. In addition, the chips thus produced using etching are separated from each other, resulting in incapability of a rapid transition to the subsequent diebonding process. This results in a poor production yield.

FR-A-2646018 discloses a semiconductor chip having a hard layer whose outer dimensions are larger than that of the substrate and which protects the semiconductor from damage during handling. Attention is also drawn to US-A-4142894, which discloses a process in which chips are diced by chemical etching.

### SUMMARY OF THE INVENTION

Figure 6 is a diagram illustrative of the problem of the present invention. It shows a method not published at the date of the present application, for dividing a semiconductor wafer into chips. In Figure 6, an elastic dicing tape 7 is attached to the rear surface of the metal layer 13. This elastic dicing tape 7 makes processes to be carried out after the dividing process easy ones. Dicing lines 8 are formed by removing portions of the semiconductor substrate 1 using chemical etching. Reference numeral 9 designates a dicing blade and numeral 10 designates a burr.

A wafer comprising the semiconductor substrate 1 and the metal layer 13 is put on the elastic dicing tape 7 and then it is divided into chips along the dicing lines 8 using the dicing blade 9. The metal layer 13 of a chip which is produced in this way has smooth side surfaces.

In the above described method for producing a semiconductor device, owing to ductility of the metal layer 13 during the dicing, a burr 10 is generated along the shape of the dicing blade 9 which is inserted toward the dicing tape 7 attached on the rear surface of the metal layer 13. This burr 10 causes an insufficient junction when the chip is diebonded on a die pad in a later process.

For example, when a semiconductor wafer comprising a GaAs semiconductor substrate of 30µm thickness and an Au layer of 50µm thickness is diced, a burr of approximately 20 to 30µm is generated on the rear surface of the Au layer.

It is an object of the present invention to provide a method of producing a plurality of semiconductor chips, by which production yield is improved and a sufficient junction can be achieved at diebonding.

Other objects and advantages of the present invention will become apparent from the detailed description given hereinafter; it should be understood, however, that the detailed description and specific embodiment are given by way of illustration only.

In carrying out the present invention, which is defined in the appended claims, a wafer comprising a semiconductor layer and a metal layer is divided into chips, a layer comprising a material having higher hardness than that of the metal layer is put on the rear surface of the metal layer via an adhesive agent, a dicing tape is attached to the rear surface of the layer having high hardness, and the wafer is divided into chips along dicing lines on the semiconductor layer using a dicing blade. Therefore, a burr on the rear surface of the metal layer owing to ductility of the metal layer is reduced. In addition, since the dicing tape is used, a rapid transition to the subsequent process is possible.

According to another aspect of the present invention, the material having higher hardness than that of the metal layer has a light transmitting property and the adhesive agent decreases its adhesion when exposed to light. Therefore, the chip can be easily removed from these materials.

### BRIEF DESCRIPTION OF THE DRAWINGS

Figure 1 is a perspective view of a semiconductor device which is produced by a production method in accordance with an embodiment of the present invention;
Figure 2 is a cross-sectional view of the semiconductor device of Figure 1;
Figure 3(a) is a cross-sectional view of a semiconductor wafer in a dicing process in accordance with an embodiment of the present invention and Figure 3(b) is an enlarged view of a portion of the wafer;
Figure 4 is a perspective view of a semiconductor device which is produced by the prior art production method;
Figure 5 is a cross-sectional view of a semiconductor wafer in a dicing process using etching in accordance with the prior art; and
Figure 6 is a cross-sectional view of a semiconductor wafer in a dicing process and is explanatory of the problem to which the present invention is directed.

### DETAILED DESCRIPTION OF THE PREFERRED EMBODIMENT

An embodiment of the present invention will be described in detail with reference to the drawings.

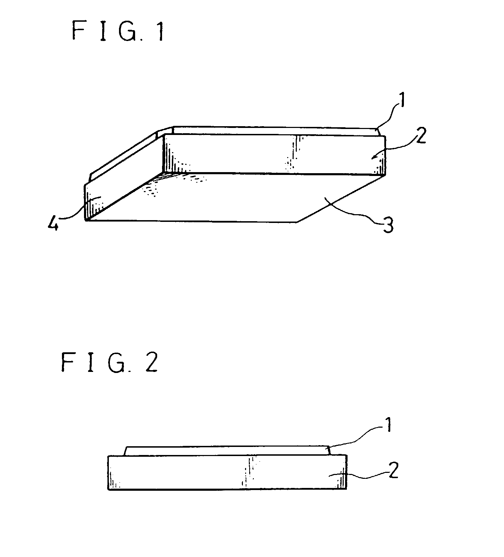

Figure 1 is a perspective view of a semiconductor chip produced by a production method in accordance with an embodiment of the present invention, viewed from its bottom surface, and figure 2 is a cross-sectional view thereof. In these figures, reference numeral 1 designates a semiconductor substrate on which an IC pattern is formed. A gilded layer 2 is connected with the IC pattern on the substrate 1 through via-holes. This gilded layer 2 serves as both of a grounding electrode and a heat sink.

In this structure, the burr of the gilded layer 2 protruding from the rear surface 3 at the side surface 4 is below 5 µm. In addition, the side surface 4 of the gilded layer 2 is produced smooth due to the dicing.

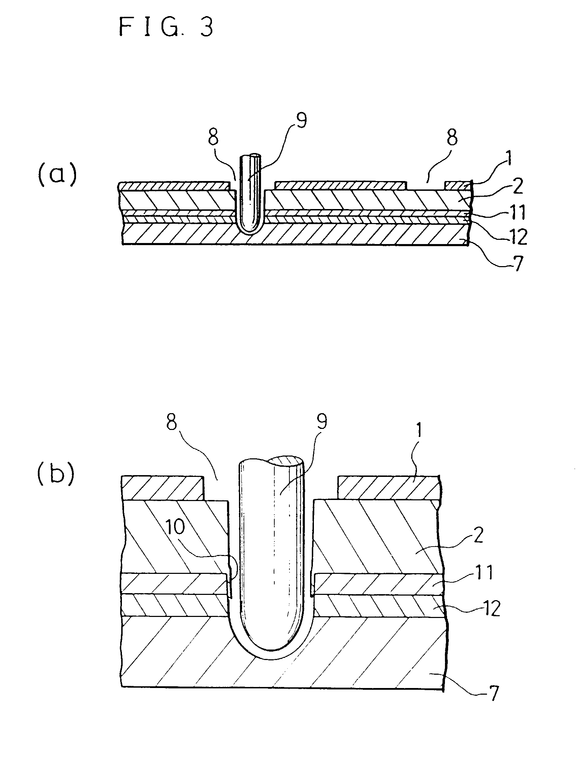

Figure 3(a) is a cross-sectional view of a semiconductor wafer in a dicing process in accordance with an embodiment of the present invention, and figure 3(b) is an enlarged view of a portion of the wafer. In these figures, the same reference numerals as those of figures 1 and 2 designate the same or corresponding parts. A sapphire wafer 12 of 150 to 200 µm thickness is attached to the rear surface of the gilded layer 2 using an adhesive agent 11 of 5 µm or less thickness so as to suppress the generation of burr due to ductility of the gilded layer 2 at the time of dicing. A dicing tape 7 is attached to the rear surface of the sapphire wafer 12. Reference numeral 9 designates a dicing blade. In addition, the adhesive agent 11 decreases its adhesion when exposed to light.

Similarly as in the prior art, the gilded layer 2 is divided into chips along the dicing lines 8, which are formed by removing portions of the substrate 1 by chemical etching, with the dicing blade 9. In this dicing process, the burr 10 due to the ductility of the gilded layer 2 is reduced to 5 µm or less, which is equal to the thickness of the adhesive agent 11, because the sapphire wafer 12 having higher hardness than that of the gilded layer 2 is provided beneath the gilded layer 2 via the adhesive agent 11.

Next, each semiconductor chip thus separated is removed from the dicing tape 7. Thereafter, light is irradiated on the semi-transparent sapphire wafer 12 at the rear surface of the chip to reduce the adhesion of the adhesive agent 11, whereby the sapphire wafer 12 is easily removed from the gilded layer 2.

In the above-described embodiment, the sapphire wafer 12 having higher hardness than that of the gilded layer 2 is put on the rear surface of the gilded layer 2 having large ductility via the adhesive agent 11, the dicing tape 7 is attached to the rear surface of the sapphire wafer 12, and then the gilded layer 2 is diced. Therefore, the burr to be generated on the rear surface of the gilded layer 2 is suppressed to about 5 µm, which is equal to the thickness of the adhesive agent 11. The burr of about 5 µm exerts no influence on the subsequent diebonding process and a sufficient junction can be achieved.

In addition, since the dicing is carried out using the dicing tape 7, it is possible that the dicing process rapidly transits to the subsequent diebonding process, resulting in an improved production yield.

Since the sapphire wafer 12 has a light transmitting property and the adhesive agent 11 decreases its adhesion when exposed to light, the sapphire wafer 12 can be easily removed from the chip by irradiating light on the sapphire wafer 12.

Furthermore, since the division of wafer into chips is performed by dicing using the dicing blade 9, the cutting plane (side surface of gilded layer 2 of each chip) is produced smooth, so that the chip size is easily controlled as compared with the case where it is performed by etching.

While in the above-described embodiment sapphire is used as a material having higher hardness than that of the metal layer 2, any other material, such as glass, may be used so long as it is harder than the metal layer 2. Also in this case, the same effect as described above can be obtained.

While in the above-described embodiment the gilded layer is used as the metal layer 2 formed on the rear surface of the semiconductor substrate 1, the same effects as described above can be obtained even when other metal layers having ductility, such as silver or copper, are used.

While in the above-described embodiment the adhesive agent 11 has a property of decreasing its adhesion when exposed to light, other adhesive agents may be used so long as the semiconductor chip is easily removed.

While in the above-described embodiment the thickness of the adhesive layer 11 is below 5 µm, it is not limited thereto. The adhesive layer may be thicker than 5 µm so long as the burr of the metal layer 2 does not affect the diebonding process.

As is evident from the foregoing description, according to the present invention, when a wafer comprising a semiconductor layer and a metal layer is divided into chips, a layer comprising a material having higher hardness than that of the metal layer is put on the rear surface of the metal layer via an adhesive agent, a dicing tape is attached to the rear surface of the layer having higher hardness, and the wafer is diced along dicing lines using a dicing blade. Therefore, the burr of the metal layer at the dicing can be reduced and a sufficient junction can be achieved in the subsequent diebonding process. In addition, since the dicing tape is used, the production yield can be improved.

Furthermore, since the layer having higher hardness has a light transmitting property and the adhesive agent decreases its adhesion when exposed to light, the chip can be easily removed from that layer by irradiating light on that layer, resulting in high work efficiency.

## Claims

1. A method of producing a plurality of semiconductor chips, comprising the steps of forming a metal layer (2) to serve as a heat sink over the rear surface (3) of a semiconductor wafer (1), forming a further layer (12) of material having a higher hardness than that of the metal layer on the rear surface of the metal layer (2), and dicing said metal layer (2) and said further layer (12) with a dicing blade (9) along dicing lines to produce a plurality of semiconductor chips,
characterised in that the further layer (12) is attached to the metal layer (2) by an adhesive (11) which permits of its subsequent removal;
prior to said dicing, a dicing tape (7) is put on the rear surface of the further layer and dicing lines are produced by etching the semiconductor wafer (1) to expose the surface of the metal layer (2); and
after said dicing the further layer is removed.

2. A method of producing a plurality of semiconductor chips in accordance with claim 1 wherein said material having a higher hardness than that of said metal layer has a light transmitting property and said adhesive decreases its adhesion when exposed to light.

3. A method of producing a plurality of semiconductor chips in accordance with claim 2 wherein said material having a higher hardness than that of said metal layer is sapphire.

4. A method of producing a plurality of semiconductor chips in accordance with claim 2 wherein said material having a higher hardness than that of said metal layer is glass.

## Patentansprüche

1. Ein Verfahren zur Herstellung einer Mehrzahl von Halbleiterchips mit den Schritten:
Bilden einer Metallschicht (2) über die rückwärtige Oberfläche (3) eines Halbleiter-Wafers (1) hinweg, die als Wärmesenke dient;
Bilden einer weiteren Schicht (12) eines Materials mit einer größeren Härte als derjenigen der Metallschicht auf der rückwärtigen Oberfläche der Metallschicht (2); und
Schneiden der Metallschicht (2) und der weiteren Schicht (12) mit einer Schneidklinge (9) entlang von Schnittlinien, um eine Mehrzahl von Halbleiterchips zu erzeugen,
dadurch gekennzeichnet, daß
die weitere Schicht (12) an der Metallschicht (2) mittels eines Klebstoffes (11) angebracht ist, der eine nachfolgende Entfernung erlaubt;
daß vor dem Schneiden ein Schneidband (7) auf die rückwärtige Oberfläche der weiteren Schicht aufgebracht wird und die Schnittlinien durch Ätzen des Halbleiter-Wavers (1) erzeugt werden, um die Oberfläche der Metallschicht (2) freizulegen; und
daß nach dem Schneiden die weitere Schicht entfernt wird.

2. Ein Verfahren zur Herstellung einer Mehrzahl von Halbleiterchips nach Anspruch 1, wobei das Material mit einer größeren Härte als derjenigen der Metallschicht eine Lichtdurchlässigkeits-Eigenschaft hat und der Klebstoff in seiner Klebewirkung abnimmt, wenn er Licht ausgesetzt wird.

3. Ein Verfahren zur Herstellung einer Mehrzahl von Halbleiterchips nach Anspruch 2, wobei das Material mit einer größeren Härte als derjenigen der Metallschicht Saphir ist.

4. Ein Verfahren zur Herstellung einer Mehrzahl von Halbleiterchips nach Anspruch 2, wobei das Material mit einer größeren Härte als derjenigen der Metallschicht Glas ist.

## Revendications

1. Un procédé pour produire une pluralité de pastilles semi-conductrices, comprenant les opérations de former une couche métallique (2) devant servir de source de chaleur sur une surface arrière (3) d'une plaquette semi-conductrice (1) de former une autre couche (12) en un matériau ayant une dureté supérieure à celle de la couche métallique sur la face arrière de la couche métallique (2), et de découper ladite couche métallique (2) et ladite autre couche (12) à l'aide d'une lame de découpe (9) le long de lignes de découpe pour produire une pluralité de pastilles semi-conductrice,
caractérisé en ce que l'autre couche (12) est fixée à la couche métallique (12) par un adhésif (11) qui permet son enlèvement subséquent ;
avant ladite découpe, un ruban de découpe (7) est placé sur la face arrière de l'autre couche et les lignes de découpe sont produites en attaquant chimiquement la plaquette semi-conductrice (1) pour exposer la surface de la couche métallique (2) ; et
après ladite découpe, l'autre couche est enlevée.

2. Un procédé pour produire une pluralité de pastilles semi-conductrices selon la revendication 1, selon lequel la matière précitée ayant une dureté supérieure à celle de la couche métallique a une propriété de transmission de lumière et ledit adhésif diminue son adhésion lorsqu'il est exposé à la lumière.

3. Un procédé pour produire une pluralité de pastilles semi-conductrices selon la revendication 2, selon lequel le matériau précité ayant une dureté supérieure à celle de la couche métallique précitée est du saphir.

4. Un procédé pour produire une pluralité de pastilles semi-conductrices selon la revendication 2, selon laquelle le matériau précité ayant une dureté supérieure à celle de la couche métallique précitée est du verre.
